# EUROPÄISCHE PATENTSCHRIFT

(11) **EP 2 741 419 B1**
(45) Veröffentlichungstag und Bekanntmachung des Hinweises auf die Patenterteilung: **21.01.2015**
(21) Anmeldenummer: 13195997.5
(22) Anmeldetag: 06.12.2013
(51) Int. Cl.: H03K 17/95

(54) **Induktiver Näherungsschalter**
Inductive proximity switch
Détecteur de proximité inductif

(30) Priorität: 10.12.2012 DE 102012222655
(43) Veröffentlichungstag der Anmeldung: 11.06.2014
(73) Patentinhaber: ifm electronic gmbh, 45128 Essen (DE)
(72) Erfinder: Weber, Michael, 88074 Meckenbeuren (DE); Hornstein, Andreas, 88149 Nonnenhorn (DE); Höß, Heribert, 88316 Isny (DE)

(56) Entgegenhaltungen:
- EP-A2- 1 416 635
- WO-A1-01/33663
- DE-A1- 1 915 044
- DE-A1- 10 249 683
- US-A- 4 378 504
- US-B1- 6 746 785

## Beschreibung

Die Erfindung betrifft einen induktiven Näherungsschalter mit einem Ferritkern, vorzugsweise einem Schalenkern, gemäß dem Patentanspruch 1.

Induktive Näherungsschalter arbeiten berührungslos und werden vor allem in der Automatisierungstechnik in großen Stückzahlen eingesetzt.
Sie werden in den verschiedensten Ausführungen unter anderem auch von der Anmelderin hergestellt und vertrieben.

Sie weisen eine von außen beeinflussbare Feldspule und eine elektronische Auswerteschaltung auf. Die Beeinflussung des Magnetfeldes der Feldspule durch eine elektrisch leitfähige oder magnetisierbare Schaltfahne wird ausgewertet. Bei Überschreiten eines Schwellwerts wird eine elektronische Schaltstufe angesteuert. Zur Konzentration der Feldlinien und der damit verbundenen Erhöhung der Empfindlichkeit sind sie meist mit einem Ferritkern ausgestattet.
Wie sich gezeigt hat, kann der Schaltabstand unter bestimmten Umständen auch kapazitiv beeinflusst werfen. Eine häufige Ursache ist die Aufladung des Ferritkerns.

Um diesen Effekt zu vermindern, ist aus der DE 1 915 044 A1 bekannt, den Ferritkern der Feldspule über eine elektrisch leitende Klebestelle mit einem festen elektrischen Potential zu verbinden und so die Ladungen abzuleiten.

Aus der DE 196 36 742 A1 ist bekannt, auf dem Ferritkern eine Metallschicht mit einem elektrisch leitfähigen und im Betriebstemperaturbereich des induktiven Näherungsschalters haftenden temperaturbeständigen Klebers zu befestigen. Eine direkte Kontaktierung des Ferritkerns wurde wegen des bekannten undefinierten Oberflächenwiderstands von Ferriten verworfen.

Aus der DE 10 2010 021 189 A1 ist bekannt, den Schalenkern form- und/oder kraftschlüssig mit der Leiterplatte zu verbinden. Zu diesem Zweck wird der Schalenkern auf die Leiterplatte geklemmt. Eine elektrische Verbindung mit dem Ferritkörper ist hier jedoch nicht vorgesehen.

Die WO 2007 / 131 374 A1 zeigt ebenfalls einen induktiven Näherungsschalter mit einem Schalenkern, wobei die Verbindung mit dem Sensorelement, genannt wird eine Spule, über steckbare Kontakte erfolgt. Eine elektrische Verbindung mit dem Schalenkern ist hier weder erwähnt, noch nahegelegt.

Die DE 41 08 886 C1 zeigt ein elektrisches Bauelement, insbesondere einen Näherungsschalter mit einer Kontaktklemme zur Verbindung des Kontaktstifts eines Steckers mit einer Leiterplatte. Anregungen zur elektrischen Verbindung eines Schalenkerns mit der Leiterplatte sind hieraus nicht entnehmbar.

Die EP 181 272 A2 zeigt ein Sensormodul mit einer Spule in einem Schalenkern. Das Sensormodul besitzt Steckkontakte, kann aber zusätzlich auch verschraubt oder geklemmt werden. Anregungen zur elektrischen Verbindung eines Schalenkerns mit der Leiterplatte sind auch hier nicht entnehmbar.

Der Nachteil des Standes der Technik besteht darin, dass die Klebung neben dem Materialeinsatz einen zusätzlichen Arbeitsgang erfordert, und die unterschiedlichen thermischen Ausdehnungskoeffizienten der Materialien die Langzeitstabilität bei häufigem Temperaturwechsel gefährden können.
Eine wesentlich effektivere elektrische Klemmverbindung mit dem Ferritkern ist nicht druckschriftlich bekannt. Offenbar wird sie von der Fachwelt als nicht praktikabel abgelehnt. Die Ursache wird zunächst in dem bereits erwähnten undefinierten hohen Oberflächenwiderstand des Ferritkerns gesehen. Außerdem besteht die Gefahr, dass die Klemmkontakte beim Verguss von Vergussmasse unterwandert und infolge der thermischen Ausdehnung der Vergussmasse angehoben werden.

Die Aufgabe der Erfindung besteht darin, sowohl Material einzusparen als auch die Montage des induktiven Näherungsschalters zu erleichtern. Insbesondere soll eine Lösung für die von der Fachwelt bisher abgelehnte elektrische Klemmverbindung angegeben werden, die auch für den Verguss mit "harten" PUR-Elektrogießharzen geeignet ist.

Diese Aufgabe wird entsprechend den Merkmalen des Patentanspruchs 1 gelöst.
Die Unteransprüche betreffen vorteilhafte Ausführungen der Erfindung.

Die wesentliche Idee der Erfindung besteht darin, für eine hohe Flächenpressung an der Kontaktstelle zu sorgen, und diese außerdem gegen das Gießharz abzudichten. So wird eine Unterwanderung der Kontaktklemme durch Gießharz verhindert.
Die bekanntlich hohen Übergangswiderstände an der Kontaktstelle haben sich wegen der geringen abzuleitenden Ladungsmenge als unkritisch erwiesen.
Wie sich gezeigt hat, wird die oxidierte Ferritkernoberfläche mit einer Kontaktspitze oder Kante bei der Montage aufgebrochen, so dass eine Vorbehandlung nicht notwendig ist. Die spätere Oxidation kann durch eine Abdichtung verhindert werden, so dass eine dauerhafte elektrische Verbindung zum Abbau von elektrischen Ladungen auf dem Ferritkern entsteht.
Diese elektrische Verbindung erfolgt erfindungsgemäß mit einer Kontaktklemme. So wird die Klebung vermieden und der Montageprozess vereinfacht und beschleunigt.
In einer vorteilhaften Ausführung wird der Kontakt zur Leiterplatte auch kraftschlüssig mit dem anderen Ender der gleichen Kontaktklemme hergestellt.
In einer weiteren vorteilhaften Ausführung soll die Kontaktklemme aus leitfähigem Kunststoff, insbesondere aus einem Metall-Kunststoff-Hybrid bestehen. So sind komplexere Formen möglich, die außerdem noch weitere Dichtungsaufgaben übernehmen können.

Die Erfindung wird anhand der Zeichnung näher erläutert.
Fig. 1 zeigt einen erfindungsgemäßen induktiven Näherungsschalter im Schnittbild.
Fig. 2 zeigt eine erfindungsgemäße Kontaktklemme in zwei Ansichten.
Fig. 3 zeigt eine Detailansicht der Kontaktstelle in der Kernbohrung.
Fig. 4 zeigt eine zweite Ausführung der Kontaktklemme.
Fig. 5 zeigt eine dritte Ausführung der Kontaktklemme.
Fig. 6 zeigt eine vierte Ausführung der Kontaktklemme.
Fig. 7 zeigt eine fünfte Ausführung der Kontaktklemme.

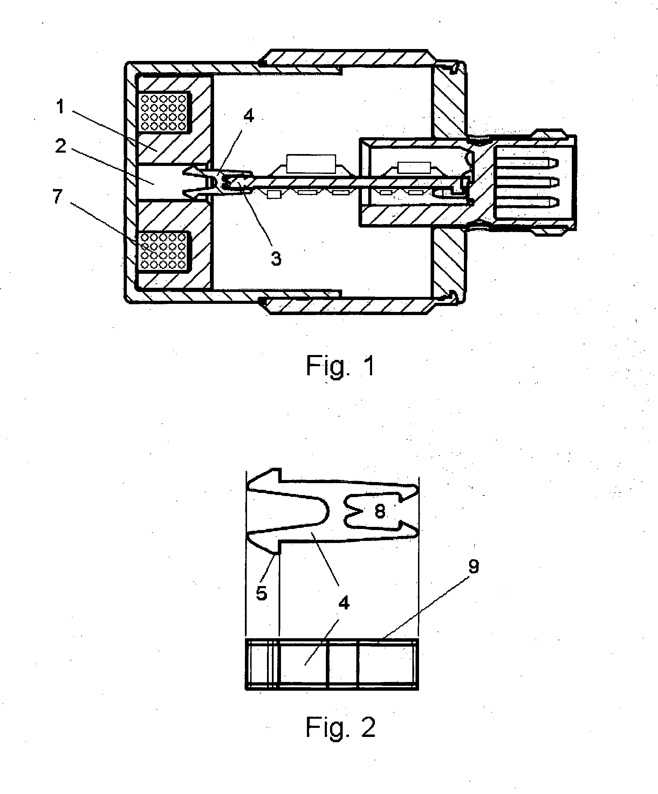

Die Fig.1 zeigt einen erfindungsgemäßen induktiven Näherungsschalter in einem zylindrischen Gehäuse, ohne die Erfindung auf Zylindergehäuse zu beschränken.
Der frontseitig angeordnete Schalenkern 1 weist eine Kernbohrung 2 auf und trägt eine von außen beeinflussbare Feldspule 7. Eine Leiterplatte 3 enthält die bekannte elektrische Auswerteschaltung zum Objektnachweis in einem Überwachungsbereich. Die notwendige elektrische Verbindung der Feldspule 7 mit der Auswerteschaltung ist hier zur Vereinfachung nicht dargestellt.
Der elektrische Kontakt zwischen dem Schalenkern 1 und der Leiterplatte 3 wird erfindungsgemäß durch eine Kontaktklemme 4 hergestellt. Die Kontaktklemme 4 ist als Stanzteil ausgeführt und besteht vorteilhaft aus korrosionsbeständigem Edelstahl.
Es wird in die Kernbohrung 2 eingeführt und ist so ausgeformt, dass insgesamt 4 Kontaktstellen mit dem Schalenkern 1 entstehen, wobei der elektrische Kontakt im Wesentlichen an den Kanten 5 der Kontaktklemme 4 entsteht. Damit sich der Raum zwischen dem Rand der Kernbohrung 2 und den Kanten 5 der Kontaktklemme 4 nicht mit Gießharz füllen kann, wird die Kontaktklemme 4 in der ersten Ausführung der Erfindung mit einer elastischen Hülle 9 überzogen. Die Hülle 9 besteht vorteilhaft aus Kunststoff. Dieser kann elektrisch leitfähig sein, was allerdings nicht unbedingt zur Realisierung der Erfindung notwendig ist, denn er wird beim Einführen in die Kernbohrung 2 von den scharfen Kanten 5 der Kontaktklemme 4 durchschnitten, so dass zwischen der Kontaktklemme 4 und der Kernbohrung 2 ein elektrischer Kontakt mit hoher Flächenpressung entsteht.
Der Überzug 9 kann durch Eintauchen oder durch Umspritzen der Kontaktklemme 4 aufgetragen werden. Vorteilhaft kann er aus einen elektrisch leitfähigem Material bestehen, was aber nicht unbedingt für die Realisierung der Erfindung erforderlich ist. Als Material kommen elektrisch leitfähige Kleber, Elastomere, oder ein leitfähige Kunststoffe, wie beispielsweise ein Kunststoff-Metall-Hybrid oder ähnliches in Frage. Die erfindungsgemäße Kontaktklemme 4 kann zusätzlich auch einen Klemmkontakt mit der Leiterplatte 3 herstellen. Das erleichtert die automatisierte Montage.
Die Kontaktklemme 4 ist vorzugsweise gehärtet. Außerdem können ihre Kanten 5 auch noch einen Grat aufweisen.

Die Fig. 2 zeigt eine erfindungsgemäße Kontaktklemme 4 in der Draufsicht und in einer Seitenansicht. Die Draufsicht (oben) zeigt die Kanten 5 und eine Kontaktspitze 8 zur Arretierung der Leiterplatte 3.
Die Seitenansicht (unten) zeigt den elastischen Überzug 9, der wie oben beschrieben vor der Montage, aber in einer weiteren Ausgestaltung der Erfindung erst nach der Montage und dann natürlich nur in der Kernbohrung 2 mit einer Kanüle aufgetragen werden kann.

Die gezeigte Kontaktklemme 4 ist für unterschiedliche Schalenkerne 1 verwendbar, sofern deren Kernbohrung 2 zur Aufnahme der Kontaktklemme 4 geeignet ist. Die Kontaktklemme 4 besteht vorzugsweise aus nichtrostendem Federbandstahl wie X10CrNi18-8 oder X12CrNi17-7.

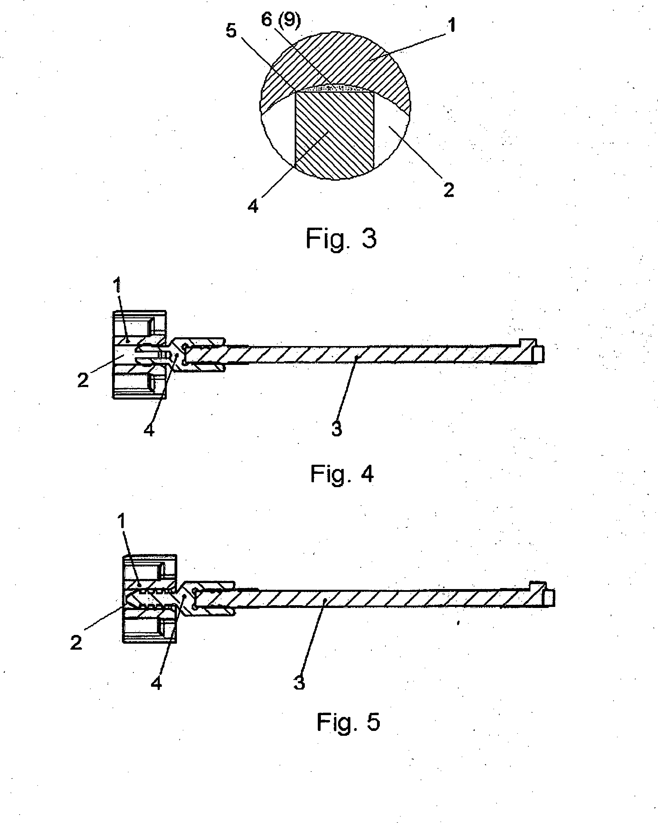

Die Fig. 3 zeigt eine Detailansicht der Kontaktstelle in der Kernbohrung 2. Oben sieht man einen Teil des Ferritkerns 1. Darunter liegt ein Ausschnitt der Kernbohrung 2 mit einem Teil der Kontaktklemme 4. Deren Kanten 5 schneiden, wie hier dargestellt, die Oberfläche des Ferritkerns 1 und brechen die meistens vorhandene Oxidschicht auf. Zwischen dem gekrümmten Rand der Kernbohrung 2 und der geraden Berandung der Kontaktklemme 4 entsteht ein Hohlraum 6, der erfindungsgemäß durch den vor oder auch nach der Montage aufgebrachten elastischen Überzug 9 ausgefüllt, und damit abgedichtet ist.
In den nachfolgend gezeigten Ausführungsbeispielen kann das auch durch eine als Dichtung ausgeformte Kontaktklemme 4 aus leitfähigem Kunststoff erfolgen.

Die Fig. 4 zeigt eine weitere Ausführung. Die Kontaktklemme 4 besteht hier aus einem elektrisch leitfähigen Kunststoff, beispielsweise aus einen Kunststoff-Metall-Hybrid. Wie sich überraschend gezeigt hat, funktioniert die Kernerdung mit einer größeren Kontaktfläche offenbar auch, ohne die oxidierte Ferritkernoberfläche aufzubrechen.
So kann die Kontaktklemme 4 kostengünstig als Spritzteil gefertigt werden. Ein Spritzteil ermöglicht komplexere Formen, so dass noch eine weitere Funktion von der Kontaktklemme 4 übernommen werden kann. So wird die Kernbohrung 2 durch die Kontaktklemme 4 abgedichtet, was das Eindringen von Gießharz und die damit verbundenen Gefahr der Anhebung der Kontakte vermindert.

Die Fig. 5 zeigt eine dritte erfindungsgemäße Ausführung. Die Kontaktklemme 4 besteht auch hier aus einem leitfähigen Kunststoff. Ihre Lamellen dienen zusätzlich zur Abdichtung, indem sie außerdem noch das Eindringen von Gießharz durch die Kernbohrung 2 in den Sensorbereich mit der Feldspule 7 verhindern.

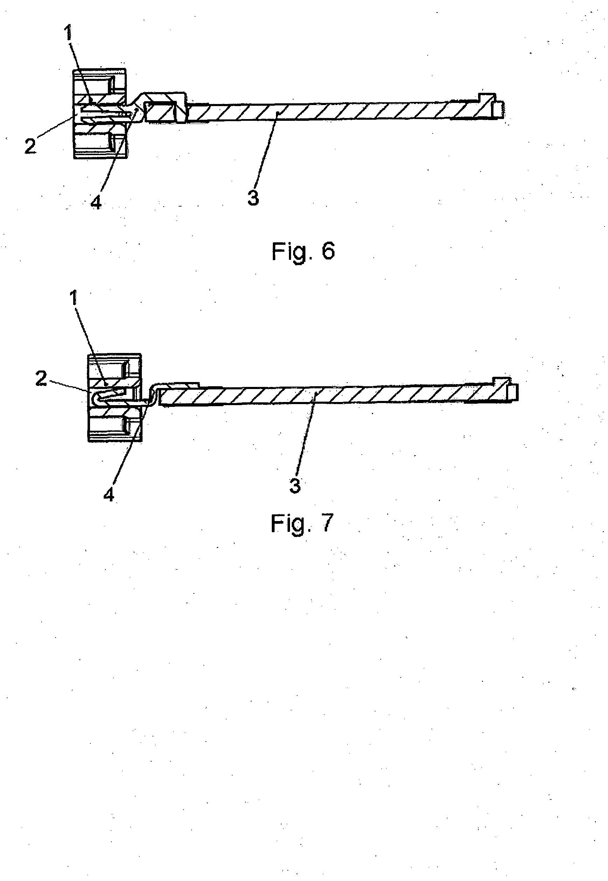

Die Fig. 6 zeigt eine vierte Ausführung. Die Kontaktklemme 4 besteht aus Federbronze wie CuSn6 und ist somit kostengünstig als Stanzteil herstellbar.
Der Kontakt zur Leiterplatte 3 wird durch eine Pressfit-Verbindung hergestellt.

Die Fig. 7 zeigt eine fünfte Ausführung. Die Kontaktklemme 4 ist mit der Leiterplatte 3 verlötet. Sie besteht ebenfalls vorteilhaft aus Federbronze (CuSn6).
Das Ausgangsmaterial ist ein Draht mit vorzugsweise rechteckigem Querschnitt. Dadurch ist diese Ausführung noch kostengünstiger als die in der Fig. 6 gezeigte.

Der erfindungsgemäße induktive Näherungsschalter weist einen Ferritkern 1 auf, der zur Ableitung von Ladungen elektrisch mit einer Leiterplatte 2 verbunden ist. Die Verbindung ist kraftschlüssig. Sie kann zusätzlich auch noch formschlüssig sein. Sie erfolgt über eine Kontaktklemme 4, die mit ihren scharfen Kanten 5 die auf dem Ferritkern 1 häufig vorhandene Oxidschicht aufbricht. Die Kontaktklemme 4 wird vorteilhaft in die bei Schalenkernen fast immer vorhanden Kernbohrung 2 eingeführt. Prinzipiell ist jede Bohrung in einen beliebig geformten Ferritkern 1 geeignet.
Die Kontaktklemme 4 kann auch kraftschlüssig mit der Leiterplatte 3 verbunden sein. Als Material kommt neben Metall auch ein leitfähiger Kunststoff-Metall-Hybrid in Frage. Der Kunststoff kann aber auch mit Leitruß, Graphit, Kohlefasern, Kohlenstoffnanoröhrchen wie Carbon Nano Tubes (CNT), oder Edelstahlfasern leitfähig gemacht werden oder intrinsisch leitfähige Polymere (ICP) aufweisen. Die Kontaktklemme 4 kann mit der Leiterplatte 3 verpresst oder veriotet sein.

### Bezugszeichenliste

- 1: Ferritkern, vorzugsweise Schalenkern
- 2: Kernbohrung (im Ferritkern)
- 3: Leiterplatte (auch Hybrid oder Leiterfilm)
- 4: Kontaktklemme zur elektrischen Verbindung von Kern 1 und Leiterplatte 3
- 5: Kante der Kontaktklemme 4 zur Kontaktierung des Ferritkerns 1
- 6: Hohlraum an der Kontaktstelle zwischen Kontaktklemme 4 und Kernbohrung 2
- 7: Feldspule
- 8: Spitze der Kontaktklemme 4 zur Arretierung der Leiterplatte 3
- 9: Elastischer Überzug (Hülle) der Kontaktklemme 4

## Patentansprüche

1. Induktiver Näherungsschalter mit einem Ferritkern (1), der eine Kernbohrung (2) aufweist und elektrisch mit einer Leiterplatte (3) verbunden ist, **dadurch gekennzeichnet, dass** eine Kontaktklemme (4) zur elektrischen Verbindung der Leiterplatte (3) mit dem Ferritkern (1) dient, wobei der Ferritkern (1) kraftschlüssig über seine Kernbohrung (2) kontaktiert wird.

2. Induktiver Näherungsschalter nach Anspruch 1, **dadurch gekennzeichnet, dass** die Kontaktklemme (4) als Stanzteil mit parallelen Seiten ausgeführt ist, so dass der elektrische Kontakt hauptsächlich durch Flächenpressung über die Kanten (5) der Kontaktklemme (4) erfolgt.

3. Induktiver Näherungsschalter nach Anspruch 2, **dadurch gekennzeichnet, dass** die Kontaktklemme (4) zumindest teilweise mit Kunststoff umhüllt ist, so dass der Kunststoff den Hohlraum (6) an der Kontaktstelle zwischen Kontaktklemme (4) und Kernbohrung (2) ausfüllt.

4. Induktiver Näherungsschalter nach Anspruch 1, **dadurch gekennzeichnet, dass** die Kontaktklemme (4) aus leitfähigen Kunststoff besteht und die Kernbohrung (2) gegen den Innenraum des Näherungsschalters abdichtet.

5. Induktiver Näherungsschalter nach einem der vorhergehenden Ansprüche, **dadurch gekennzeichnet, dass** ein kraftschlüssiger elektrischer Kontakt zwischen der Leiterplatte (3) und der Kontaktklemme (4) vorhanden ist.

6. Induktiver Näherungsschalter nach einem der vorhergehenden Ansprüche, **dadurch gekennzeichnet, dass** die Kontaktklemme (4) mit der Leiterplatte (3) verpresst ist.

7. Induktiver Näherungsschalter nach einem der Ansprüche 1 bis 4, **dadurch gekennzeichnet, dass** die Kontaktklemme (4) mit der Leiterplatte (3) verlötet ist.

## Claims

1. Inductive proximity switch having a ferrite core (1) which has a core hole (2) and is electrically connected to a printed circuit board (3), **characterized in that** a contact terminal (4) serves to electrically connect the printed circuit board (3) to the ferrite core (1), wherein contact is made with the ferrite core (1) in a non-positive manner by means of its core hole (2).

2. Inductive proximity switch according to Claim 1, **characterized in that** the contact terminal (4) is designed as a stamped part with parallel sides, so that the electrical contact is made mainly by surface pressure over the edges (5) of the contact terminal (4).

3. Inductive proximity switch according to Claim 2, **characterized in that** the contact terminal (4) is at least partially encased with plastic, so that the plastic fills the hollow space (6) at the contact point between the contact terminal (4) and the core hole (2).

4. Inductive proximity switch according to Claim 1, **characterized in that** the contact terminal (4) is composed of conductive plastic and seals off the core hole (2) from the interior of the proximity switch.

5. Inductive proximity switch according to one of the preceding claims, **characterized in that** there is non-positive electrical contact between the printed circuit board (3) and the contact terminal (4).

6. Inductive proximity switch according to one of the preceding claims, **characterized in that** the contact terminal (4) is press-connected with the printed circuit board (3).

7. Inductive proximity switch according to one of Claims 1 to 4, **characterized in that** the contact terminal (4) is soldered to the printed circuit board (3).

## Revendications

1. Détecteur de proximité inductif comprenant un noyau en ferrite (1) qui présente un alésage de noyau (2) et qui est connecté électriquement à une carte à circuits imprimés (3), **caractérisé en ce qu'**une borne de contact (4) sert à la connexion électrique de la carte à circuits imprimés (3) au noyau en ferrite (1), le noyau en ferrite (1) étant mis en contact par engagement par force par le biais de son alésage de noyau (2).

2. Détecteur de proximité inductif selon la revendication 1, **caractérisé en ce que** la borne de contact (4) est réalisée sous forme de pièce estampée avec des côtés parallèles de sorte que le contact électrique se produise principalement par pression superficielle par le biais des arêtes (5) de la borne de contact (4).

3. Détecteur de proximité inductif selon la revendication 2, **caractérisé en ce que** la borne de contact (4) est au moins en partie enveloppée de plastique, de sorte que le plastique remplisse la cavité (6) au niveau du point de contact entre la borne de contact (4) et l'alésage de noyau (2).

4. Détecteur de proximité inductif selon la revendication 1, **caractérisé en ce que** la borne de contact (4) se compose de plastique conducteur et étanchéifie"l'alésage de noyau (2) vis-à-vis de l'espace intérieur cavité du détecteur de proximité.

5. Détecteur de proximité inductif selon l'une quelconque des revendications précédentes, **caractérisé en ce qu'**un contact électrique par engagement par force est prévu entre la carte à circuits imprimés (3) et la borne de contact (4).

6. Détecteur de proximité inductif selon l'une quelconque des revendications précédentes, **caractérisé en ce que** la borne de contact (4) est pressée avec la carte à circuits imprimés (3).

7. Détecteur de proximité inductif selon l'une quelconque des revendications 1 à 4, **caractérisé en ce que** la borne de contact (4) est brasée à la carte à circuits imprimés (3).
